# EUROPEAN PATENT APPLICATION

(11) **EP 1 589 571 A1**
(43) Date of publication of application: **26.10.2005**
(21) Application number: 05008747.7
(22) Date of filing: 21.04.2005
(51) Int. Cl.: H01L 21/60

(54) **Semiconductor device and method of manufacturing the same**

(30) Priority: 22.04.2004 JP 2004126936
(71) Applicant: SEIKO EPSON CORPORATION, Tokyo 160-0811 (JP)
(72) Inventor: Kori, Toshiaki, Suwa-shi, Nagano-ken 392-8502 (JP)
(74) Representative: HOFFMANN EITLE

(57) **Abstract**

In order to provide a semiconductor device which can simplify processing, make a wiring pitch superfine, and improve reliability of electrical connections when electrically connecting the semiconductor chip and the wiring substrate, a semiconductor device (10) comprises a wiring substrate (11) on which a semiconductor chip (12) is mounted. An insulating part (13) made up of a resin is set up on the side of the semiconductor chip (12), and a terminal (25) of the semiconductor chip (12) and a terminal (22) of the wiring substrate (11) are electrically connected through wiring (14) formed on the insulating part (13).

## Description

### [Field of the Invention]

The present invention relates to a semiconductor device and its manufacturing process, electro-optical equipment, and electronic equipment, and more particularly to techniques of mounting a semiconductor chip on a wiring substrate.

### [Background]

In COB (Chip On Board) techniques of mounting a semiconductor chip on a wiring substrate, a conventional technique called "wire bonding" is typically used to connect electrically through wiring the semiconductor chip and the wiring substrate. In addition, there is a method of connecting one terminal to another with an alloy layer or an electrical contact (for example, refer to Patent Document 1).

### [Patent Prior Art]

Some background art relating to the present invention is disclosed in the following patent document: Patent Document 1: Japanese Unexamined Patent Publication No. 2000-216330.

### [Disclosure of the Invention]

### [Problems/Object to be solved by the Invention]

In a technique of using wire bonding, making a wiring pitch superfine (for example, under 100µm) is difficult. Further, in a technique of connecting one terminal to another with an alloy layer or an electrical contact, its connection processing step tends to be complicated. Also, improvement of the reliability of electric connections is desired.

The present invention has been made in view of the above-mentioned circumstances. It is an object thereof to provide a semiconductor device and its manufacturing process which can simplify processing when connecting electrically a semiconductor chip and a wiring substrate, making a wiring pitch superfine, and improving the reliability of electrical connections.
It is also another object thereof to provide electro-chemical equipment and electronic equipment which accomplished cost reduction and quality improvement.

### [Means to Solve the Problem]

To achieve the above-mentioned objects, a semiconductor device according to the present invention is a semiconductor device provided with a wiring substrate on which a semiconductor chip is mounted, the semiconductor chip having a side on which an insulating part constituted by a resin is provided, with a terminal of the semiconductor chip and a terminal of the insulating part being electrically connected through wiring formed on the insulating part.

According to this semiconductor device, inasmuch as a terminal of the semiconductor chip and a terminal of the wiring substrate are electrically connected through wiring formed on the insulating part provided on the side of the semiconductor chip, it is apparent that simplification of processing of wiring formation, making a wiring pitch superfine, and improvement of the reliability of electrical connections have been attained.

At this point, the semiconductor chip may be such as to have a first surface arranged opposite to the wiring substrate and a second surface on an opposite side to the first surface, with the terminal of the semiconductor chip being set up on the second surface.

Further, there may be a difference in a level between the terminal of the semiconductor chip and the terminal of the wiring substrate.

In this case, it is preferable for the insulation part to have a slant surface corresponding to the difference in a level. That the insulating part has the slant surface facilitates formation of the above wiring.

In the semiconductor device, it is acceptable for the wiring to include a plated film formed according to the plating process.
By using the plating process, making a pitch of the above wiring superfine and processing to form wiring can be easily simplified, and also secure electrical connections can be attained.

In this case, it is acceptable for the wiring to include an undercoat film which will become an undercoating of the plated film.
The undercoat film accomplishes improvement of a junction strength of the plated film.

Electro-chemical equipment of the present invention comprises the above-mentioned semiconductor device. Further, electronic equipment of the present invention comprises the above-mentioned semiconductor device. Low cost and quality improvement may be accomplished by means of the electro-chemical equipment and the electronic equipment.

A manufacturing process of a semiconductor device of the present invention is a process of manufacturing a semiconductor device provided with a wiring substrate on which a semiconductor chip is mounted, comprising the steps of:
setting up an insulating part constituted by a resin on a side of the semiconductor chip; and
forming on the insulating part wiring electrically connecting a terminal of the semiconductor chip and a terminal of the wiring substrate.

According to the manufacturing process of the semiconductor device, by forming wiring, which connects electrically the terminal of the semiconductor chip and the terminal of the wiring substrate, on the insulating part provided at the side of the semiconductor chip, simplifying the processing of wiring formation, making a wiring pitch superfine, and improving the reliability of electrical connections can be accomplished.

In this case, it is preferable for the insulating part to have a slant surface corresponding to the difference in a level between the terminal of the semiconductor chip and the terminal of the wiring substrate
That the insulating part has the slant surface facilitates forming the above-mentioned wiring.

Further, by forming the above-mentioned wiring through the use of the plating process, making a wiring pitch superfine and simplifying the processing of wiring formation can be easily achieved, and secure electrical connections can be made.
Further advantageous embodiment and improvements of the invention may be taken from the dependent claims. Furthermore, it should be noted that the invention can comprise other embodiments which result from a combination of features which have been separately shown in the drawings and disclosed in the claims and the description.

### [Brief Description of the Drawings]

In the drawings:
- **FIG. 1**: is a sectional view along line I - I of FIG, 2;
- **FIG. 2**: is a plan view to explain a semiconductor device according to an embodiment of the present invention;
- **FIG. 3A - FIG. 3C**: are diagrams to explain a manufacturing process of a semiconductor device according to an embodiment of the present invention;
- **FIG. 4**: is a diagram to explain electro-chemical equipment (organic EL equipment) according to an embodiment of the present invention; and
- **FIG. 5**: is a perspective view of an embodiment of electronic equipment of the present invention.

### [Description of the Preferred Embodiments]

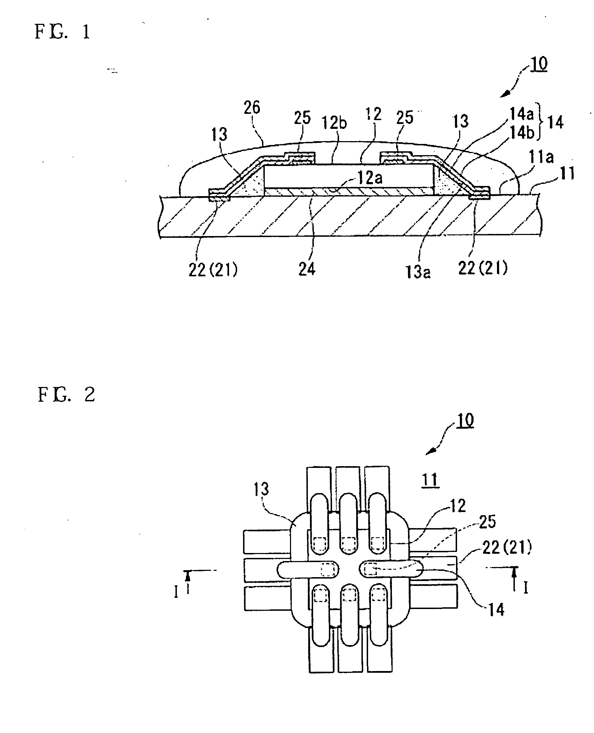

Preferred embodiments of the present invention will be described below with reference to the drawings
FIG. 1 is a diagram explaining a semiconductor device according to an embodiment of the present invention, and is a sectional view along line I -- I.

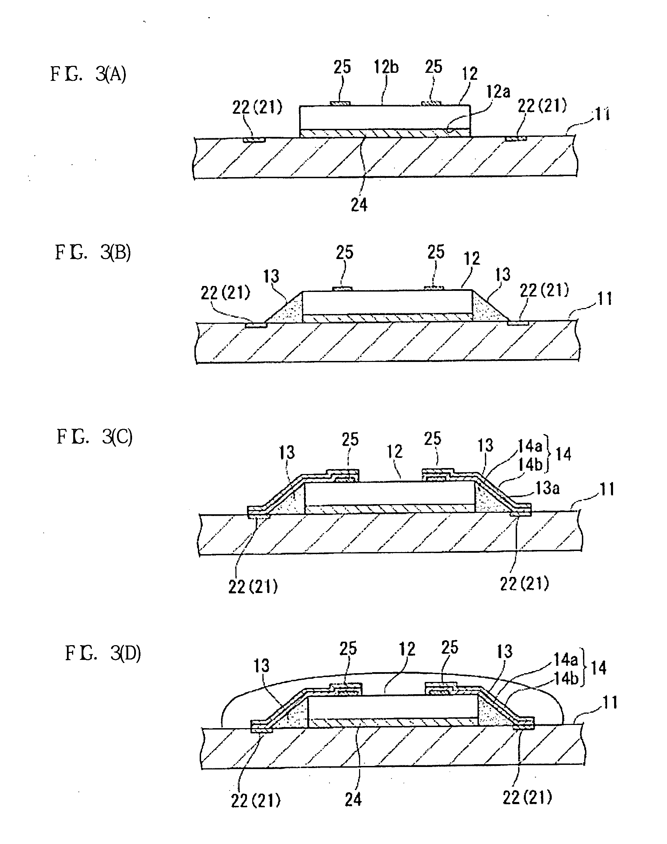

FIG. 2 is a plan view explaining a semiconductor device according to an embodiment of the present invention.

A semiconductor device 10 is configured by including a wiring substrate 11, a semiconductor chip (IC chip) 12 to be mounted on the wiring substrate 11, an insulating part 13 formed at a side of the wiring substrate, wiring 14 connecting electrically the wiring substrate 11 and the semiconductor chip 12, and the like.

The wiring substrate 11 consists of an insulating material such as a resin and ceramic. A wiring pattern 21 is formed on the wiring substrate 11. The wiring pattern 21 includes a terminal (terminal on a substrate side) 22 as an exposed portion formed on a mounted surface 11a of the semiconductor chip 12. The wiring pattern 21 may have un-illustrated land (portion wider than a line). Further, the wiring substrate 11 may be a multi-layer substrate (including a double-side substrate). In this case, the multi-layer substrate includes a multi-layer (over two layers) conductor pattern. Also, the wiring pattern 21 may include a conductor pattern built in the wiring substrate 11 (substrate). Further, the wiring substrate 11 may be a wiring substrate of a type built in a part. To be specific, inside the wiring substrate 11, passive parts such as a resistor, a capacitor, and an inductor or active parts such as an integrated circuit part may be connected electrically to the conductor pattern or a resistor may be formed by forming part of the conductor pattern with a material of high resistance value. The wiring substrate 11 may be another chip larger than the semiconductor chip 12.

For example, an integrated circuit is formed on the semiconductor chip 12. The semiconductor chip 12 has a first surface 12a arranged opposite to the wiring substrate 11 and a second surface 12b (active surface) opposite 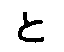 the first surface 12a.

The first surface 12a of the semiconductor chip 12 may be connected electrically or may not be connected to an un-illustrated integrated circuit. A passivation film (electrically insulation film) may be formed or may not be formed on the first surface 12a. The first surface 12a may be formed of a semiconductor (or a conductor).

Further, an adhesive layer 24 lies between the first surface 12a of the semiconductor chip 12a and the wiring substrate 11. The adhesive layer 24 is constituted by, for example, an adhesive agent. If the adhesive agent 24 has conductive property, it is possible to connect electrically the terminal 22 of the wiring substrate 11 of the first surface 12a of the semiconductor ship 12. Further, if the adhesive layer 24 has electrical insulation property, it is possible to insulate electrically the terminal 22 of the wiring substrate 11 and the first surface 12a of the semiconductor ship 12.

On the other hand, a plurality of terminal 25 are formed on the second surface 12b of the semiconductor chip 12. The first surface 12a and the second surface 12b are formed, for example, in a quadrilateral (for example, rectangle). A plurality of terminals 25 may be formed on a periphery (edge part) of the second surface 12b. For example, the plurality of terminals 25 may be arrayed along four sides of the second surface 12b or may be arrayed along two sides.

It should be noted that there may be formed on the second surface 12b at least a layer of passivation film which is an un-illustrated electrical insulation film The passivation film may be formed of only a non-resin material (for example, SiO₂ or SiN), and on top of that there may be further included a film consisting of a resin (for example, a polyamide resin). In this case, it is preferable that an opening be formed such as to expose at least part (for example, a central portion) of the plurality of terminals 25.

An insulating part 13 is formed of a material (for example, a resin) having electrical insulation property. The insulating part 13 may be formed of a material different from the adhesive layer 24. The insulating part 13 is provided on the side of the semiconductor chip 12. The insulating part may be set up in a manner of surrounding the semiconductor chip 12, or may be set up only adjacent to the terminal 25 of the semiconductor chip. The insulating part 13 may be in contact with the side of the semiconductor chip 12. Namely, it may be such that no gap is formed between the insulating part 13 and the semiconductor chip 12. In an example shown in FIG. 1, the insulating part 13 is set up such that its height is about equal to or not exceeding the height (for example, about 20µ m) of the semiconductor chip 12. When the heights of the semiconductor chip 12 and the insulating part 13 are about the same, there is hardly any difference in a level between the insulating part 13 and the semiconductor chip 12. It is acceptable for the insulating part 13 to cover only a portion made up of the semiconductor or the conductor out of the sides of the semiconductor chip 12.

Further, the insulating part 13 has a slant surface 13a declining from the semiconductor chip 12 in an outward direction corresponding to the difference in a level between the terminal 25 of the semiconductor chip 12 and the terminal 22 of the wiring substrate 11. It is positioned such that the thickest portion of the insulating part 13 is closest to the semiconductor chip 12, while the thinnest portion is farthest from the semiconductor chip 12. The insulating part 13 may be formed above part of a wiring pattern 21 (to be specific, refer to its terminal 22).

Wiring 14 is formed on the insulating part 13. The wiring 14 runs over the insulating part 13, part thereof is distributed on the terminal 25 of the semiconductor chip 12, another part thereof is distributed on the terminal 22 of the wiring substrate 11. Namely, the wiring 14 electrically connects between the terminal 25 of the semiconductor chip 12 and the terminal 22 (wiring pattern 21) of the wiring substrate 11. The pattern of the wiring 14 includes, for example, a pattern of a line width of about 20 µm and a pitch of 50 - 100 µm.

Further, the wiring 14 includes an undercoat film 14a formed on the insulating part 13 and a plated film 14b formed on the undercoat 14a. The undercoat film 14a is constituted by a barrier layer (barrier metal) formed on a surface of the insulating part 13 and a seed layer ( seed electrode). The barrier layer prevents components of the plated film 14b from dissipating and consists of TiW (titanium tungsten), TiN (titanium nitride), TaN (tantalum nitride), and the like. On the other hand, the seed layer is what serves as an electrode when the plated film 14b is formed by the plating process to be mentioned later and consists of Cu, Au, Ag, and the like. The plated film 14b is composed of conductive materials of low electric resistance such as Cu and W. It should be noted that if the plated film 14b is formed of a conductive material which is poly-S (polysilicon) that is doped with impurities such as B and P, it is possible to dispense with the above-mentioned barrier layer.

It should be noted that in the semiconductor device 10, a sealant 26 sealing at least part of the semiconductor chip 12 is placed as appropriate. In this case, the sealant 26 at least seals, for example, an electrical connection between the wiring 14 and the terminal 25 of the semiconductor chip 12 and an electrical connection between the wiring 14 and the terminal 22 (wiring pattern 21) of the wiring substrate 11.

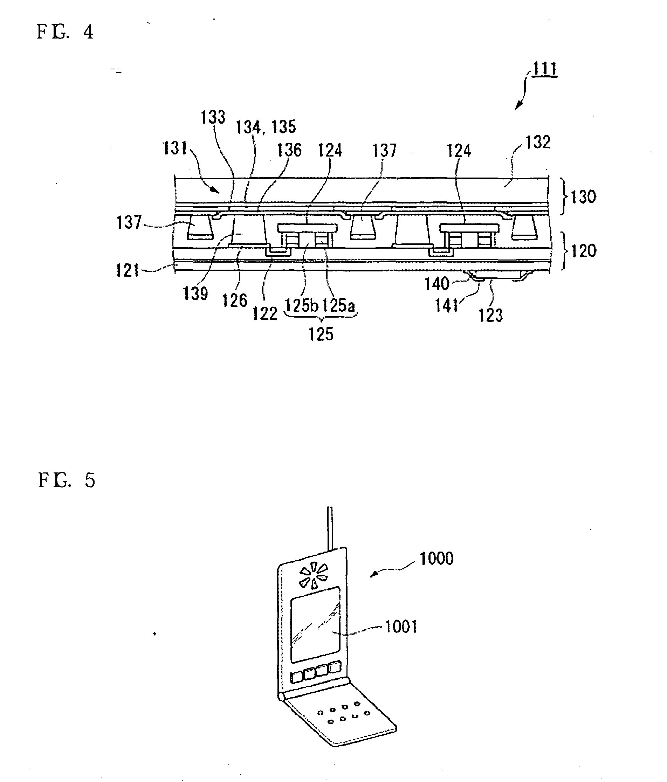

FIG. 3 A-C are diagrams explaining a manufacturing process of a semiconductor device according to the present invention. As shown in FIG. 3 A, the semiconductor chip 12 is mounted on the wiring substrate 11. To be specific, it is mounted such that the second surface 12b (activation surface) may not face against the wiring substrate 11 (face-up mounting) so as to put its first surface 12a opposite to the wiring substrate 11. In the present example, the adhesive agent is placed between the wiring substrate 11 and the semiconductor chip 12 to form the adhesive layer 24.

As shown in FIG. 3 B, the insulating part 13 is formed on the side of the semiconductor chip 12. The insulating part 13 is formed by setting up a material different from the adhesive agent forming the adhesive layer 24. As materials forming the insulating part 13, there are cited resins such as polyimide resin, silicon denatured polyimide resin, eposy resin, silicon denatured epoxy resin, benzocyclobutene (BCB), and polybenzoxazole (PBO). The insulating part 13 is formed so that it may have a slant surface 13a declining from the semiconductor chip 12 to the outward direction. The insulating part 13 may be formed in such a way as to contact the side of the semiconductor chip 12. The insulating part 13 may be formed through potting of a liquid resin or may be formed by sticking a dry film. Or after a material of the insulating part 13 is placed over the entire surface of the wiring substrate 11, the insulating part 13 may be formed by patterning. Due to gravity and the like, the material is placed slantwise corresponding to a height of the side of the semiconductor chip 12, and as a result, there is formed the insulating part 13 having the slant surface 13a.

As shown in FIG. 3 C, wiring 14 is formed. The wiring 14 is formed so as to run from the terminal 25 of the semiconductor chip 12 through over the insulating part 13 to above the terminal 22 of the wiring pattern 21. In the present example, after forming the undercoat film 14a, the plated 14b is formed by the plating process. Details are described as follows.

First, the undercoat film 14a is formed.
To be specific, a barrier layer is formed at the undercoat film 14a, and a seed layer is formed thereon. The barrier layer and the seed layer are formed by using, for example, the PVD (Physical Vapor Deposition) such as vacuum evaporation, sputtering, and ion plating, the CVD, the IMP (Ion Metal Plasma), and the electroless plating process, and the like.

First, the plated film 14b is formed.
To be specific, first a photoresist is coated over the entire surface on top of the wiring substrate 11. As the photoresist, a liquid photoresist for plating or a dry film may be employed. It should be noted that a photoresist used when etching an Al electrode typically set up in a semiconductor device or a resin photoresist having insulation property may be used, provided that it is resistant to a plating solution or an etching solution to be used in a process mentioned later. Photoresist coating is carried out by means of spin coating, dipping, spray coating and the like. Pre-bake is performed after photoresist coating.

Next, the photoresist is subjected to burning according to a planar shape of the plated film 14b (wiring 14) to be formed. To be specific, the photoresist is subjected to patterning by performing exposure processing and development processing with a mask on which a specified pattern is formed. The pattern of the wiring 14 includes, for example, a line width of approx. 20 µm and a pitch of about 50-100 µm.

Thereafter, with this photoresist as the mask, a conductive material is filled in an opening provided on the photoresist, thus forming the plated film 14b. Filling of the conductive material is performed by the plating process. For the plating process, for example, electro-chemical plating (ECP) is employed. It should be noted that as an electrode in the plating process, a seed layer consisting of the undercoat film 14a is used. By this means, the conductive material is filled in the opening formed on the photoresist, thus forming the wiring 14. Then, a remover and the like are used to remove the photoresist. It should be noted that for the remover, aqueous ozone and the like may be used. Next, in an area where the plated film 14b is not formed, the undercoat film 14a in an exposure state is removed by dry etching and the like.

Now, in the foregoing example, the plated film 14b was formed by way of filling the opening of the photoresist film, but it is not limited to this example. For example, by means of patterning after the plated film 14b is formed on the entire surface of the wiring substrate 11, there may be formed the plated film 14b (wiring 14) of a desired pattern.

Next, as shown in FIG. 3 D, a sealant 26 ia placed as necessary. The sealant 26 may be formed by a transfer mold or potting. The sealant 26 may be omitted.

Through a series of steps described above, the semiconductor chip 12 is mounted on the wiring substrate 11. At the same time, the terminal 25 of the semiconductor chip 12 and the terminal 22 of the wiring substrate 11 are electrically connected by the wiring 14.

According to the present embodiment, simplifying the processing of wiring formation, making the wiring pitch superfine, and improving the reliability of electrical connections may be attained.
Namely, despite the difference in a level between the terminal 25 of the semiconductor chip 12 and the terminal 22 of the wiring substrate 11, the insulating part 13 is set up on the side of the semiconductor chip 12, and connecting between both terminals 22 and 25 with the wiring 14 running over this insulating part 13, so that processing from one side of the wiring substrate 11 is sufficient when connecting electrically the semiconductor chip 12 and the wiring substrate 11, thereby making it possible to use simple processing such as the plating process.

Especially, since the insulating part 13 has the slant surface 13a corresponding to the difference in a level between both terminals 22 and 25 and the wiring 14 is formed on this slant surface 13a, the formation of wiring is made easy and secure by comparison to a case of forming wiring on a vertical surface.

At this point, it is possible for the plating process to form a plurality of wiring in one lot. Additionally, in combination with photolithography, it is easier to make the wiring pitch superfine (for example, under 100 µ m).
Further, in the present embodiment, the wiring 14 is formed by arranging the wiring material directly on the terminals 22 and 25, it is possible to make electrical connections of high reliability as compared to a technique of connecting with electrical contacts and the like.

Now, in the foregoing example, the slant surface 13a of the insulating part 13 is assumed to be relatively flat, but it is not limited to this. For example, a concavity or a convexity may exist on the slant surface 13a.

FIG. 4 is a diagram explaining an electrochemical device according to an embodiment of the present invention.
The electro-chemical equipment of FIG. 4 is organic EL equipment 111 which is equipped to match an organic electroluminescence (hereinafter referred to as "organic EL") element to a pixel.

The organic EL equipment 111 is constituted by joining the wiring substrate 120 and an organic EL substrate 130 (light-emitting element substrate) through the use of an imprint technique called SUFTLA (Surface Free Technology by Laser Ablation) (registered trademark). Now, as for the above imprint technique, it is described, for example, in Japanese Unexamined Patent Publication No. Hei10-125929, Japanese Unexamined Patent Publication No. Hei10-125930, Japanese Unexamined Patent Publication No. Hei 10-125931, and the like.

The wiring substrate 120 comprises a multi-layer substrate 121, a wiring pattern 122 of a specified pattern formed thereon, a semiconductor chip 123 as a circuit part connected to the wiring pattern 122, a TFT (switching element) 124 driving the organic EL element 131, a TFT connecting part 125 joining the TFT 124 and the wiring pattern 122, and an organic EL connecting part 126 joining the organic EL element 131 and the wiring pattern 122.
At this point, the TFT connecting part 125 is formed according to a terminal pattern of the TFT 124. It is constituted by, for example, a bump (conductive protrusion) 125a formed by non-electrolytic plating and the like and a junction material 125b to be placed on the bump 125a.
An organic EL substrate 130 consists of a transparent substrate 132 through which a ray of emitted light passes, a first electrode (anode) 133 made up of a transparent metal such as ITO, an organic functional layer (hole injection/transport layer 134, a light-emitting layer 135), a second electrode (cathode) 136, and a cathode separator 137. The hole injection/transport layer may be formed between the light-emitting layer 135 and the second electrode 136.
Further, a sealing paste 138 is filled in between the wiring substrate 120 and the organic EL substrate 130, while there is provided a conductive paste 139 which permits electrical continuity between the organic EL connecting part 126 and the anode 136.

In the present embodiment, there are used techniques described from FIG. 1 to FIG. 3 above in connecting the semiconductor chip 123 and the wiring substrate 120. Namely, there is provided an insulation part 140 having a slant surface on the side of the semiconductor chip 123, and through wiring 141 formed on this insulating part 140, the semiconductor chip 123 and the wiring substrate 120 are electrically connected. Consequently, as a result of simplifying the processing of wiring formation, making the wiring pitch superfine, and improving the reliability of electrical connections, low cost and quality improvement have been achieved for this organic EL device 111. It should be noted that the techniques described from FIG. 1 to FIG. 3 above may be used to connect the TFT 124 and the wiring substrate 129.

FIG. 5 shows an embodiment of electronic equipment of the present invention.
The electronic equipment of the present embodiment is mounted with the organic EL device 111 shown in FIG. 4 above as display means. FIG. 5 is a perspective view showing an example of a mobile phone, and a reference numeral 1000 indicates a mobile phone body, and a reference numeral 1001 indicates a display unit using the above-mentioned organic EL device 1. As a result of simplifying the processing of wiring formation, making the wiring pitch superfine, and improving the reliability of electrical connections, low cost and quality improvement have been achieved for this electronic equipment

While there has been described preferred embodiments according to the present invention with reference to the attached drawings, it is needless to say that the present invention is not restricted to such examples. Those skilled in the art will recognize that many variations and modifications are possible within the technical spirit and scope of the appended claims, and it is understood that all such variations and modifications fall within the true technical scope of the present invention.

### List of used Reference Numerals

- 10: Semiconductor device,
- 11: Wiring substrate,
- 12: Semiconductor chip,
- 13: Insulating part,
- 13a: Slant surface,
- 14: wiring,
- 14a: Undercoat film,
- 14b: Plated film,
- 21: Wiring pattern,
- 22, 25: Terminal,
- 12a: First surface,
- 12b: Second surface,
- 24: Adhesive layer,
- 26: Sealant,
- 111: Organic EL equipment (electro-chemical equipment).

## Claims

1. A semiconductor device provided with a wiring substrate on which a semiconductor chip is mounted, the semiconductor chip having a side on which an insulating part consisting of a resin is set up, with a terminal of the semiconductor chip and a terminal of the insulating part being electrically connected through wiring formed on the insulating part.

2. The semiconductor device according to Claim 1, wherein:
the semiconductor chip has a first surface arranged opposite to the wiring substrate and a second surface opposite to the first surface, the terminal of the semiconductor chip being provided on the second surface.

3. The semiconductor device according to Claim 1 or Claim 2, wherein:
there is a difference in a level between the terminal of the semiconductor chip and the terminal of the wiring substrate.

4. The semiconductor device according to Claim 3, wherein:
the insulating part has a slant surface corresponding to the difference in a level.

5. The semiconductor device according to any of Claim 1 to Claim 4, wherein:
the wiring includes a plated film formed according to a plating process.

6. The semiconductor device according to Claim 5. wherein:
the wiring includes an undercoat film which will become a undercoating of the plated film with respect to the insulating part.

7. Electro-optical equipment comprising a semiconductor device according to any of Claim 1 to Claim 6.

8. Electronic equipment comprising a semiconductor device according to any of Claim 1 to Claim 6.

9. A manufacturing process of a semiconductor device provided with a wiring substrate on which a semiconductor chip is mounted, comprising the steps of:
setting up an insulating part constituted by a resin on a side of the semiconductor chip; and
forming on the insulating part wiring electrically connecting a terminal of the semiconductor chip and a terminal of the wiring substrate.

10. The manufacturing process of a semiconductor device according to Claim 9, wherein:
the insulating part has the slant surface corresponding to the difference in the level between the terminal of the semiconductor chip and the terminal of the wiring substrate.

11. The manufacturing process of a semiconductor device according to Claim 10, wherein:
the wiring is formed by using the plating process.
